Europäisches Patentamt

European Patent Office

Office européen des brevets

(11) Veröffentlichungsnummer : **0 061 787**
**B1**

(12)     ` EUROPÄISCHE PATENTSCHRIFT

(45) Veröffentlichungstag der Patentschrift :
21.11.85

(21) Anmeldenummer : 82200215.0

(22) Anmeldetag : 22.02.82

(51) Int. Cl.⁴ : **H 01 L 21/223**, H 01 L 21/225, H 01 L 21/31

(54) Verfahren zum Dotieren von Trägern aus Silicium für die Halbleiterfertigung.

(30) Priorität : 02.03.81 CH 1372/81

(43) Veröffentlichungstag der Anmeldung :
06.10.82 Patentblatt 82/40

(45) Bekanntmachung des Hinweises auf die Patenterteilung : 21.11.85 Patentblatt 85/47

(84) Benannte Vertragsstaaten :
CH DE FR GB LI SE

(56) Entgegenhaltungen :
EP-A- 0 001 038
EP-A- 0 019 272
DE-B- 1 160 105
FR-A- 2 280 974
JP-A-52 034 666
US-A- 4 050 967
Patent Abstracts of Japan, Seite 3163 E 77

(73) Patentinhaber : BBC Aktiengesellschaft Brown,
Boveri & Cie.
Haselstrasse
CH-5401 Baden (CH)

(72) Erfinder : Vlasak, Thomas
Adelmatt 336
CH-5242 Birr (CH)

## Beschreibung

Die vorliegende Erfindung geht aus von einem Verfahren zum örtlich selektiven Dotieren gemäss dem Oberbegriff des Anspruchs 1. Ein solches Verfahren ist z. B. aus der US-A 4 050 967 bekannt.

In der Halbleiterfertigung, z. B. zur Herstellung von integrierten Schaltungen, Leistungshalbleiter-Bauelementen und dergleichen, ist es üblich, die erforderliche Dotierung eines im wesentlichen aus Silicium bestehenden flächigen Trägers — im folgenden auch kurz als « Si-Substrat » bezeichnet — mindestens teilweise durch eine allgemein als Diffusionsverfahren (« Impurity Diffusion ») bezeichnete Methode zu bewirken.

Je nach Art und Verwendung des herzustellenden Halbleiters kann das angewendete Diffusionsverfahren mit unterschiedlichen Dotiermitteln, unterschiedlichen Methoden zur örtlichen Begrenzung bzw. Steuerung der Dotierung und mit unterschiedlichen Verfahrensschrittfolgen durchgeführt werden.

Beispiele für bekannte Dotiermittel sind Arsen, Antimon und Phosphor (Donator- bzw. n-Dotierung) bzw. Bor, Gallium und Aluminium (Akzeptor- bzw. p-Dotierung), die in elementarer oder gegebenenfalls chemisch gebundener, z. B. oxidischer Form, verdampft und auf den Träger aufgebracht werden können.

Typische Beispiele für bekannte Methoden zur örtlichen Begrenzung der Dotierung sind einerseits das Abdecken bzw. Maskieren des Si-Substrates in den nicht zu dotierenden Bereichen und andererseits das nachträgliche, örtlich selektive Entfernen von vorgängig relativ flach dotierten Bereichen, gegebenenfalls mit nachfolgender thermischer Behandlung.

(« Drive-in-Stufe »), um das Dotiermittel in den nach der selektiven Entfernung noch verbleibenden dotierten Bereichen tiefer in das Si-Substrat einzudiffundieren.

Von diesen beiden Methoden zur örtlichen selektiven Dotierung ist das Abdecken bzw. Maskieren in der Regel die im Vergleich zur nachträglichen Entfernung einfachere Methode ; hinzu kommt, dass für das lokale Abtragen der durch Eindiffundieren gebildeten Si/Dotiermittel-Phase die darunterliegende, d. h. durch nachträgliches Entfernen der Si/Dotiermittel-Phase freigelegte Schicht vorbestimmte Eigenschaften besitzen muss, die nicht immer oder nur mit Schwierigkeiten erzielbar sind. Schliesslich kann auch die beim nachträglichen Entfernen der Si/Dotiermittel-Phase meist entstehende Grubenstruktur einer sonst praktisch planaren Oberfläche des Si-Substrates nachteilig sein.

Voraussetzung für das dementsprechend aus mehreren Gründen vorteilhaftere Abdecken (d. h. das Maskieren einer vorbestimmten zusammenhängenden Fläche) bzw. Maskieren (d. h. das Abdecken von vorbestimmten Teilbereichen einer Fläche) der nicht zu dotierenden Bereiche des Si-Substrates ist aber eine Abdeck- bzw. Maskenschicht, die den Zutritt des Dotiermittels zu dem unter der Abdeck- bzw. Maskenschicht liegenden Teil des Substrates unter den Verfahrensbedingungen wirksam verhindert bzw. verzögert. Da die Dotierung durch Diffusion bei hohen Temperaturen von typisch über 500 °C erfolgt. sind bekannte Abdeck- oder Maskenschichten mit organischen Anteilen, wie etwa die üblichen Fotolackmasken, wegen ihrer thermischen Zersetzbarkeit hier grundsätzlich ungeeignet.

Eine für Diffusionsverfahren an sich bekannte und thermisch beständige Abdeck- oder Maskenschicht ist eine solche aus Siliciumdioxid, z. B. in Form einer auf dem Si-Substrat « aufgewachsene » und etwa durch Aufdampfen von Silicium in Gegenwart von Spurenmengen Sauerstoff auf den Träger aus Silicium erhältlichen Schicht, oder in Form einer aufgeschmolzenen, z. B. glasartigen Schicht auf Basis von Siliciumdioxid.

Es ist aber bekannt (siehe z. B. R. M. Burger und P. P. Donovan, « Fundamentals of Silicon Integrated Device Technology », Prentice-Hall, USA, 1967, Band I, Seite 153-155), dass von den üblichen p-Dotiermitteln nur Bor einen ausreichend kleinen Diffusionskoeffizienten in Siliciumdioxid besitzt, um die Verwendung einer anhaftenden Abdeck- oder Maskenschicht aus Siliciumdioxid für die wirksame Abdeckung bzw. Maskierung des Si-Substrates zu ermöglichen.

Gallium hingegen diffundiert bei typischen Diffusionstemperaturen im Bereich von 800-1 300 °C etwa 400mal schneller durch Siliciumdioxid als durch Silicium ; für Aluminium gilt eine ähnliche Grössenordnung und man kann davon ausgehen, dass Aluminium unter den hier interessierenden Temperaturbedingungen mindestens 100mal schneller durch Siliciumdioxid als durch Silicium diffundiert.

Wenn ein Si-Substrat mit anhaftender « Maskenschicht » aus Siliciumdioxid im Diffusionsverfahren mit Gallium oder Aluminium dotiert wird, geschieht dies wie in der genannten Literaturstelle vermerkt unter der Annahme, dass der Diffusionseffekt dieser Dotiermittel unter der Siliciumdioxidschicht des Si-Substrates identisch ist mit dem ohne eine anhaftende Siliciumdioxidschicht erzielten Diffusionseffekt.

Dies bedeutet, dass eine auf dem Si-Substrat bei der Diffusion zur Dotierung mit Aluminium oder Gallium vorhandene Abdeck- oder Maskenschicht aus anhaftendem Siliciumdioxid für andere vorgängige oder nachfolgende Behandlungsschritte bzw. Halbleiterfunktionen dienlich sein bzw. bleiben kann, aber sich keinesfalls als wirksame Masken- oder Abdeckschicht für das örtlich selektive Dotieren mit Aluminium oder Gallium eignet.

Ebensowenig wirksam wie eine anhaftende Maskenschicht aus Siliciumdioxid ist jedoch auch eine mechanisch lösbare Maskenplatte aus Silicium, wie sie aus der EP-A 0 001 038 bekannt ist und vorzugsweise als Ersatz für eine Photolackschicht in der Halbleitertechnologie verwendet wird.

Im Unterschied zu Siliciumdioxid ist Siliciumnitrid auch für p-Dotiermittel, wie Aluminium, derart undurchlässig, dass es sich als Abdeck- oder Maskenschicht für das örtlich selektive Dotieren von Si-Substraten eignen würde. Der zur Bildung von Siliciumnitridschichten auf Siliciumsubstraten erforderliche Verfahrens- und Apparateaufwand ist aber so gross und die Reproduzierbarkeit derart unsicher, dass sich diese Massnahme jedenfalls für die technische Fertigung kaum eignet.

Da Aluminium als p-Dotiermittel für Si-Substrate an sich vorteilhaft ist, weil es im Silicium vergleichsweise rasch diffundiert und einfach zu handhaben ist, hat man seit längerer Zeit nach einer Maske für die Aluminiumdiffusion gesucht, die einerseits wirkungsvoll und andererseits einfach zu handhaben ist.

Aus der eingangs zitierten Druckschrift ist es nun bekannt, für die selektive Al-Diffusion eines Si-Substrats eine fest am Substrat haftende Maskierungsschicht vorzusehen, welche aus der Kombination einer $SiO_2$-Schicht und einer polykristallinen Si-Schicht besteht. Eine solche kombinierte Maskierungsschicht ist zwar wirkungsvoll, erfordert jedoch das Aufbringen einer zusätzlichen Schicht.

Aufgabe der Erfindung ist die Schaffung eines Verfahrens zum örtlich selektiven Dotieren von Si-Substraten mit Aluminium durch Diffusionsverfahren unter Verwendung einer Abdeckung oder Maske, die das Eindiffundieren des Aluminiums in den unmittelbar unter der Abdeckung oder Maske liegenden Bereich des Si-Substrates praktisch verhindert, d. h. unter den Verfahrensbedingungen während der Behandlungsdauer mindestens ebenso verzögert wie das Si-Substrat, und die vergleichsweise einfach anzuwenden ist.

Diese Aufgabe wird bei einem Verfahren der eingangs genannten Art durch die Merkmale aus dem Kennzeichen des Anspruchs 1 gelöst. Als « anliegend » wird hierbei ein mechanischer und lösbarer Kontakt zwischen zwei Flächen verstanden, der normalerweise durch eine äussere Krafteinwirkung, wie z. B. einer Presskraft, bewirkt wird und durch eine entsprechende Gegenkraft, z. B. Hubkraft, oder durch Beendigung der äusseren Krafteinwirkung, z. B. Beendigung der Presskrafteinwirkung, gelöst werden kann.

Der Erfindung liegt folgender experimenteller Befund zugrunde :

(a) Wenn in einer Diffusionskammer unter den Bedingungen der Dotierung mit Aluminium plane glatte und voneinander beabstandete Probenscheiben aus Silicium mit oder ohne Beschichtung aus Siliciumdioxid behandelt werden, wird sowohl an den freien Siliciumoberflächen als auch unter den mit Siliciumdioxid bedeckten Oberflächen eine praktisch gleichmässige Dotierung mit Aluminium festgestellt, was mit den Lehren des Standes der Technik übereinstimmt und die Unwirksamkeit von Schichten aus Siliciumdioxid zur Abdeckung bzw. Maskierung des unter der Siliciumdioxidschicht liegenden Si-Substrates bestätigt ;

(b) auch wenn zwei dicht aneinanderliegende Probeplatten aus Silicium ohne Siliciumdioxidschichten in dieser Weise behandelt werden, sind alle Siliciumflächen, also auch die in der Grenzfläche aneinanderliegenden Oberflächen eines Plattenpaares mit Aluminium dotiert ;

(c) wenn hingegen eine der beiden in der Grenzfläche aneinanderliegenden Oberflächen eines Plattenpares vorher mit einer Schicht aus Siliciumdioxid versehen wird, findet man in der mit Siliciumdioxid beschichteten Platte unter der Siliciumdioxidschicht keine Aluminiumdotierung, während alle freien Oberflächen und auch die an der Siliciumdioxidschicht mechanisch anliegende aber nicht mit einer anhaftenden Siliciumdioxidschicht versehene Plattenoberfläche mit Aluminium dotiert sind ;

(d) ist ein Teil der Siliciumdioxidschicht auf der einen Platte nicht von der anderen Platte abgedeckt, so findet man unter diesem nicht abgedeckten Teil der anhaftenden Siliciumdioxidschicht ebenfalls eine Aluminiumdotierung des Si-Substrates ;

(e) sind beide Platten des Paares an den mechanisch aneinanderliegenden Flächen, d. h. an der Kontaktgrenzfläche, jeweils mit einer anhaftenden Siliciumdioxidschicht versehen, so findet sich bei keiner der beiden Platten unter der jeweiligen Siliciumdioxidschicht eine Aluminiumdotierung.

Dies bedeutet, dass das mechanische Aneinanderliegen von Platten bei der Dotierung mit Aluminium nur dann eine wirksame Abschirmung ermöglicht, wenn mindestens eine Oberfläche im abgedeckten Bereich eine anhaftende Siliciumdioxidschicht trägt. Die den überraschenden Teilbefunden (c) und (e) zugrunde liegenden Ursachen sind noch nicht geklärt ; es kann aber wegen der Teilbefunde (b) und (d) ausgeschlossen werden, dass eine rein mechanische, körperliche Abschirmung zur Vermeidung der Dotierung mit Aluminium ausreicht, ebensowenig wie eine nichtabgedeckte anhaftende Siliciumoxidschicht hierzu wirksam ist. Möglicherweise wirkt eine körperlich abgedeckte $SiO_2$-Schicht hier nach Art eines Getters.

Dass die Kombination einer für sich als Abschirmung gegen die Aluminiumdiffusion unwirksamen Siliciumdioxidschicht mit einer für sich als Abschirmung ebenfalls unwirksamen mechanischen Abdeckung die Aluminiumdiffusion durch die anhaftende Siliciumdioxidschicht in den darunterliegenden Bereich des Si-Substrates wirksam verhindern kann, war keinesfalls zu erwarten, zumal die Verwendung von Siliciumdioxidschichten als Abdeck- oder Maskenschichten bei der Dotierung von Si-Substraten mit Aluminium durch Diffusion ausdrücklich als ungeeignet vorbeschrieben ist und sich die beispielsweise aus der Technik des Aufdampfens dünner Filme bekannte Verwendung mechanischer Masken (siehe z. B. L. I. Maissel et al, « Handbook of Thin Film Technology », MacGraw Hill, 1970, Seiten 7-2 bis 7-4) ausweislich des experimentellen Teilbefundes (b) im Versuch zur Verhinderung der Aluminiumdiffusion in den abgedeckten Bereich des Si-Substrates als allein unwirksam erweist.

Die erfindungsgemässe Lehre der Eignung einer mit einer mechanischen Abdeckung bzw. Maske belegten, am abzudeckenden Flächenbereich des Substrates oder Trägers anhaftenden Siliciumdioxidschicht als Mittel zur Verhinderung der Aluminiumdiffusion in den unter der abgedeckten Siliciumdioxidschicht liegenden Bereich des Substrates bietet eine bedeutsame Vereinfachung der p-Dotierung von Si-Substraten für die Halbleiterfertigung, was weiter unten noch eingehender erläutert wird.

Der erfindungsgemäss behandelte Träger, d. h. das Si-Substrat, besteht im wesentlichen, d. h. im Regelfall zu mehr als 50 Gew.% und vorzugsweise zu mehr als 90, beispielsweise zu mindestens 99 % seines Gewichtes aus Silicium in der für die Halbleiterfertigung üblichen elementaren Form mit ausreichender Reinheit und geeigneter Kristallstruktur. Der Träger ist « flächig », d. h. er besitzt mindestens eine praktisch ebene Oberfläche, die während des Diffusionsverfahrens abgedeckt oder maskiert werden kann. Uebliche Formen flächiger Träger aus Silicium sind polygonale, z. B. rechteckige, oder runde, z. B. kreisförmige Platten mit zwei praktisch parallelen Hauptflächen. Typische Beispiele für geeignete Si-Substrate sind kreisförmige Scheiben aus Silicium mit Dicken von 100 μm bis 3 mm und Gewichten von 0,2 g bis 50 g.

Solche und ähnliche Si-Substrate mit ein- oder beidseitig anhaftender aufgewachsener $SiO_2$-Schicht, z. B. mit $SiO_2$-Schichtdicken von 50 nm bis 10 μm, sind technisch erhältlich bzw. können nach bekannten Verfahren hergestellt und für das erfindungsgemässe Verfahren verwendet werden.

Platten- bzw. plättchenförmige Si-Substrate mit aufgewachsener $SiO_2$-Beschichtung von ≥ 50 nm Dicke auf einer Seite (Hauptfläche) werden für viele Zwecke der Erfindung bevorzugt.

Das Diffusionsverfahren wird meist in bekannten Diffusionsöfen durchgeführt, d. h. in vakuumdichten Kammern, die zur Aufnahme einer entsprechenden Zahl oder Charge von beabstandet voneinander angeordneten Trägern bemessen sind und das Beheizen der Träger auf Temperaturen von typisch 800 bis 1 300 °C ermöglichen.

Als p-Dotiermittel wird in an sich bekannter Weise Aluminium, vorzugsweise in reiner elementarer Form, verwendet und in an sich bekannter Weise während des Diffusionsverfahrens zur Verdampfung gebracht. Hierbei wird meist im Hochvakuum gearbeitet, z. B. bei Vakuumwerten von $10^{-3}$ Torr oder besser, z. B. von $10^{-5}$ Torr oder besser. Gewünschtenfalls kann vor dem Evakuieren die im Diffusionsofen vorhandene Luft durch Stickstoff oder Edelgas verdrängt werden.

Der erfindungsgemässe Verfahren kann bei den für Diffusionsverfahren üblichen Temperaturen zwischen 800 und 1 300 °C, vorzugsweise im Bereich von 1 000 bis 1 250 °C, während vorbestimmter Zeitspannen durchgeführt werden. Die Behandlungsdauer richtet sich nach der gewünschten Diffusionstiefe des Dotiermittels und liegt typisch im Bereich zwischen 1 min und 10 Stunden, z. B. im Bereich von 10 bis 200 min. Typisch ist für eine Aluminiumdiffusionstiefe von 2 μm im Si-Substrat bei etwa 1 000 °C eine Zeitspanne von etwa 100 min ausreichend.

Als Abdeck- oder Maskenplatten werden flächige, d. h. mindestens eine ebene Fläche besitzende Gebilde aus Werkstoffen bevorzugt, die nicht nur unter den Verfahrensbedingungen praktisch inert sind, sondern überdies keine unerwünschten Verunreinigungen für das Si-Substrat enthalten, d. h. auch kein zufällig vorhandenes Dotiermittel. Bevorzugte Abdeck- oder Maskenplatten besitzen wie die Si-Substrate vorzugsweise zwei praktisch parallele Hauptflächen.

Die Dicke der Abdeck- oder Maskenplatte richtet sich allgemein nach der Diffusionsgeschwindigkeit von Aluminium im Material der Abdeck- oder Maskenplatte in dem Sinne, dass die für das Hindurchdiffundieren des Dotiermittels durch die Abdeck- oder Maskenplatte erforderliche Zeitspanne vorzugsweise unter den Verfahrensbedingungen mindestens ebenso gross sein sollte wie die zum vollständigen Hindurchdiffundieren des Aluminiums durch das Si-Substrat erforderliche Zeitspanne. Abdeck- oder Maskenplatten aus elementarem Silicium werden für viele Zwecke bevorzugt ; in diesem Fall wird die Dicke der Abdeck- oder Maskenplatte vorzugsweise mindestens etwa gleich bemessen, wie die Dicke des Si-Substrates.

Wenn andere Werkstoffe, wie beispielsweise Keramik, für die Abdeck- oder Maskenplatten verwendet werden, ist es zweckmässig, entsprechend dickere Platten zu wählen, wenn die Diffusionsgeschwindigkeit von Aluminium unter den Verfahrensbedingungen in diesen Werkstoffen grösser ist als in Silicium. So kann beispielsweise eine Abdeck- oder Maskenplatte aus Siliciumdioxid, z. B. aus Quarz oder Quarzglas, erfindungsgemäss verwendet werden, wenn diese Platte mindestens etwa 500mal und z. B. etwa 1 000mal dicker ist als die vorgesehene Diffusionstiefe im Si-Substrat.

Es ist zu betonen, dass die Abdeck- oder Maskenplatte beim erfindungsgemässen Verfahren mechanisch, d. h. lösbar an der Siliciumdioxidschicht anliegt, die ihrerseits fest und nicht ohne weiteres lösbar auf dem abgedeckten bzw. maskierten Substrat haftet. z. B. als aufgewachse oder aufgeschmolzene Siliciumdioxidschicht. In der Praxis ist es zweckmässig, dass die Abdeck- oder Maskenplatte mit einem gewissen Flächendruck, z. B. von mindestens 1 Pa und vorzugsweise 5 Pa oder mehr an der Siliciumdioxidschicht anliegt.

Vorzugsweise liegt die Abdeck- oder Maskenplatte in dem gegen die Eindiffusion von Aluminium abzuschirmenden und mit anhaftender

SiO$_2$-Schicht versehenen Oberflächenbereich des Si-Substrates möglichst eng an. Quantitativ bedeutet dies, dass sowohl die am Substrat haftende Siliciumdioxidschicht als auch die mechanisch daran anliegende Oberfläche der Abdeck- oder Maskenplatte vorzugsweise jeweils Ebenheitswerte, bestimmt nach ISO-Norm 1302, von besser als □ 5 µm und Rauhigkeitswerte, ebenfalls bestimmt nach ISO-Norm 1302, von besser als Ra = 0,4 µm haben.

Gemäss einer für die technische Halbleiterfertigung, insbesondere die Herstellung von Leistungshalbleitern, besonders bevorzugten Ausführungsform des erfindungsgemässen Verfahrens werden jeweils zwei platten- oder plättchenförmige gleichgrosse Si-Substrate gleicher Dicke und einseitiger Beschichtung aus aufgewachsenem Siliciumdioxid zu sandwichartigen Paaren aneinandergelegt, bei welchen die Siliciumdioxidschichten aneinanderliegen und jeweils das eine Substrat eines Paares als Abdeckplatte für das andere Substrat wirkt. Nach Durchführung des erfindungsgemässen Verfahrens kann die an den Si-Substraten anhaftende SiO$_2$-Schicht vollständig oder bereichsweise entfernt werden, z. B. mit üblichen Aetzmethoden ; für viele Verwendungs- bzw. Fertigungszwecke kann die SiO$_2$-Schicht aber auch am Si-Substrat verbleiben.

Die Zeichnung dient der weiteren Erläuterung bevorzugter Ausführungsformen der Erfindung ; es zeigen :

Figur 1 die schematische Schnittansicht eines Si-Substrates auf einer Abdeckplatte,

Figur 2 die schematische Schnittansicht eines an einer Maskenplatte anliegenden Si-Substrates,

Figur 3 die schematische Schnittansicht einer Mehrzahl von Si-Substraten mit einer gemeinsamen Abdeckplatte,

Figur 4 die schematische Seitenansicht einer Mehrzahl von sandwichartig zusammengesetzten si-Substrat-Paaren in einer Vorrichtung zur einfachen Randhalterung der Paare und

Figur 5 die schematische Draufsicht auf eine Vorrichtung zur mehrfachen Randhalterung mit eingeschobenen Paaren von sandwichartig zusammengelegten Si-Substraten.

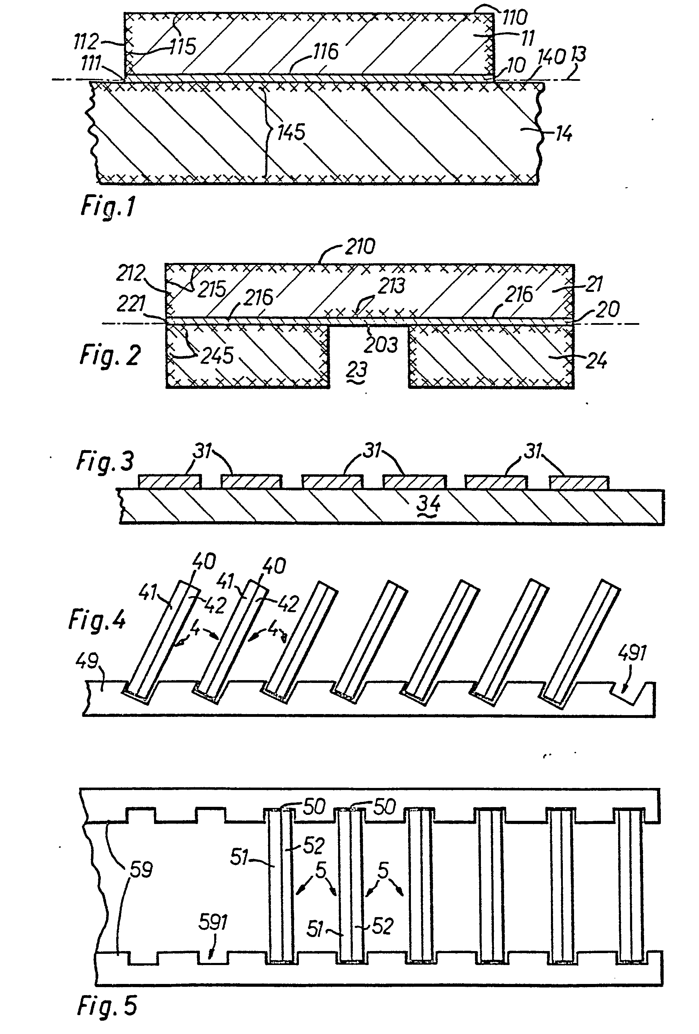

Fig. 1 zeigt in einem schematischen vergrösserten Querschnitt einen aus Silicium bestehenden kreisscheibenförmigen Träger 11 mit zwei planparallelen Hauptflächen 110, 111. Die eine Hauptfläche 111 wird von einer (übertrieben dick gezeichneten) anhaftenden glatten Schicht 10 aus aufgewachsenem SiO$_2$ mit einer dicke von 0,2 bis 2 µm gebildet, die auf der ebenen glatten Oberfläche 140 einer Abdeckplatte 14, z. B. aus elementarem Silicium, liegt. Die strichpunktiert angedeutete Grenzfläche 13 zwischen der Hauptfläche 111 des Trägers oder Substrates 11 und der Oberfläche 140 der Abdeckplatte hat vorzugsweise eine praktisch unmessbar kleine Dicke.

Bei der Dotierung mit Aluminium in einem Diffusionsofen bei etwa 10$^{-5}$ Torr und etwa 1 000 °C werden die kreuzschaffiert angedeuteten Bereiche 115 der oberen, d. h. freiliegenden Hauptfläche 110 des Trägers 11 und dessen ebenfalls freiliegende Randfläche 112 mit Aluminium dotiert, wobei die Diffusionstiefe von der Behandlungsdauer bzw. allfälligen Aenderungen der Behandlungstemperatur abhängt.

Auch die kreuzschraffiert angedeuteten Bereiche 145 auf beiden Seiten der Abdeckplatte 14 werden dabei mit Aluminium dotiert.

Während die obere Fläche der Abdeckplatte 14 auch im Bereich der in der Grenzschicht 13 durch den Träger 11 abgedeckten Oberfläche mit Aluminium dotiert wird, findet man im Bereich 116 hinter der SiO$_2$-Schicht 10 des Trägers 11 keine Dotierung mit Aluminium.

Die « Lateraldiffusion » des Aluminiums in die Grenzfläche 13 im Aussenrandbereich der SiO$_2$-Schicht 10 ist meist gleich der « Vertikaldiffusion », wie sie senkrecht zu den freiliegenden Oberflächen 110, 112 des Trägers und durch diese Flächen in den Träger hinein auftritt, kann aber bei entsprechend schlechterer Oberflächenqualität auch zwei bis fünfmal grösser sein, ohne dass dies die Brauchbarkeit der erhaltenen Produkte stört. Je nach Verwendungszweck der Endprodukte kann auch eine Lateraldiffusion, die das Zehnfache der Vertikaldiffusion oder mehr berträgt, noch annehmbar sein, wenn das Verhältnis des wirksam maskierten bzw. abgedeckten Bereiches zu dem durch Lateraldiffusion dotierten Bereich gross ist oder/und die für gegebene Oberflächenqualitäten der Grenzflächen anhand von einfachen Versuchen vorher ermittelte Lateraldiffusion für die Dimensionierung der nicht zu dotierenden Bereiche in Reichnung gestellt wird.

Nach der Diffusionsbehandlung wird die Platte 11 von der Abdeckplatte 14 abgehoben und ist zur Weiterbearbeitung nach bekannten Verfahren bereit.

Wenn die Abdeckplatte 14 erneut für das erfindungsgemässe Verfahren verwendet werden soll, werden ihre Kontaktoberflächen vorzugsweise durch übliche Aetzverfahren vom eindiffundierten Aluminium befreit.

Fig. 2 zeigt, wiederum in schematischem und vergrössertem Querschnitt, einen Träger 21 aus Silicium, dessen mit einer aufgewachsenen SiO$_2$-Schicht 20 versehene kreisförmige Hauptfläche 221 auf einer Abdeck- oder Maskenplatte 24 aufliegt ; diese Platte 24 ist eine Lochscheibe aus Silicium und hat praktisch die gleiche Dicke und den gleichen Aussendurchmesser wie der Träger 21.

Wiederum werden bei der Dotierung mit Aluminium durch Diffusion unter den oben genannten Bedingungen die freiliegenden Oberflächen des Trägers 21 in den durch Kreuzschraffierung angedeuteten Bereichen 215 (obere Hauptfläche 210 und Randfläche 212) mit Aluminium dotiert, ebenso alle Oberflächen der Maskenplatte 24.

Im Bereich der Durchbrechung 23, die als Maskenfenster wirkt, ist ein Teil 203 der SiO$_2$-Schicht des Trägers 21 nicht abgedeckt und lässt daher das Aluminium durchdiffundieren, so dass der Träger 21 hier nach der Diffusionsbehandlung auch hinter der anhaftenden, aber nicht abgedeckten SiO$_2$-Schicht 203 einen mit Aluminium dotierten Teilbereich 213 im Zentrum des im übrigen nicht dotierten Bereiches 216 zeigt.

Bezüglich der Lateraldiffusion, der Weiterverarbeitung des Trägers 21 und der Wiederverwendung der Maskenplatte 24 gilt das oben zu Fig. 1 Gesagte.

Fig. 3 zeigt in schematischer Schnittdarstellung eine Mehrzahl von Trägern 31, die mit ihrer (nicht dargestellten) SiO$_2$-Schicht der jeweils unteren Hauptfläche auf einer gemeinsamen ebenen glatten Abdeckplatte 34, z. B. aus Silicium, liegen. Dies entspricht einer für den technischen Betrieb geeigneten Ausführungsform des erfindungsgemässen Verfahrens, wenn die Abdeckplatte 34, oder mehrere solche Platten, mit aufgelegten Trägern oder Si-Substraten 31 in einem Diffusionsofen der örtlich selektiven, d. h. die abgedeckte Hauptfläche der Träger 31 praktisch dotierungsfrei haltenden Diffusionsbehandlung mit Aluminium, z. B. unter den oben genannten Verfahrensbedingungen, unterzogen werden.

Zu den in den Fig. 1 bis 3 dargestellten Ausführungsformen ist zu bemerken, dass die Träger 11, 21 und 31 jeweils mit einem Druck von typisch etwa 5 Pa auf der Abdeck- bzw. Maskenplatte 14, 24 bzw. 34 anliegen.

Die in den Fig. 4 und 5 in schematischer Seitenansicht bzw. Draufsicht dargestellten Trägerpaaranordnungen illustrieren eine besonders bevorzugte Ausführungsform des erfindungsgemässen Verfahrens : Gemeinsames Merkmal ist hierbei, dass jeweils zwei identische Si-Substrate oder Träger 41, 42 bzw. 51, 52 zu Trägerpaaren 4, 5 vereinigt sind, bei welchen die jeweils auf einer Hauptfläche mit einer aufgewachsenen SiO$_2$-Schicht versehenen Träger 41, 42 und 51, 52 sandwichartig mit aneinanderliegenden SiO$_2$-Schichten 40, 50 in entsprechende Ausnehmungen 491, 591 der Rahmenelemente 49, 59 eingeschoben sind.

Die Trägerpaare 4 von Fig. 4 werden durch das noch teilweise wirksame Gewicht der jeweils oberen (in Fig. 4 linksseitigen) Platte jedes Paares aneinandergedrückt. Das in Fig. 5 dargestellte Rahmenelement 59 kann wahlweise « stehend », d. h. mit annähernd horizontal liegenden Plattenpaaren 5, oder « liegend », d. h. mit annähernd senkrecht stehenden Plattenpaaren 5, oder in einer Zwischenstellung im Diffusionsofen angeordnet werden.

Wenn die Plattenpaare mit der Horizontalen Winkel von Null bis etwa 80° einschliessen, kann das Eigengewicht der jeweils oberen Platte für den Anliegedruck noch ausreichen. Bei annähernd senkrecht (90° ± 10°) stehenden Plattenpaaren sind die Ausnehmungen des Rahmenelementes 59 zweckmässig so ausgebildet, dass die beiden Platten jedes eingeschobenen Plattenpaares aneinandergedrückt werden. Dies kann einfach z. B. durch eine entsprechende (nicht dargestellte) trapezförmig bzw. konisch sich verjüngende Querschnittsform der Ausnehmungen 591 oder durch Einlagekeile und andere Presshalterungsmittel erzielt werden.

Die Rahmenelemente 49 bzw. 59 können ein- oder mehrteilig ausgebildet sein und bestehen allgemein aus bei den Verfahrensbedingungen inerten und von unerwünschten Fremdelementen freien Werkstoffen ; Silicium ist als Beispiel eines bevorzugten Materials für die Horden oder Rahmenelemente 49, 59 zu nennen.

Die in den Fig. 4 und 5 erläuterte paarweise Anordnung der Träger ermöglicht eine vergleichsweise sehr hohe Packungsdichte im Diffusionsofen ; da keine besonderen Abdeckplatten verwendet werden, sondern jeweils die eine Platte eines Paares als Abdeckung für die andere Platte wirkt, entfällt die Notwendigkeit der Reinigung von Abdeckplatten ; eine quantitative Entfernung von eindiffundiertem Aluminium von den Rahmenelementen 49, 59 zwischen den Diffusionsbehandlungen ist vergleichsweise weniger kritisch, da die Rahmenelemente nur randseitig mit den Trägern in Berührung kommen.

Da einseitig oder in anderer Weise selektiv mit SiO$_2$ beschichtete Si-Substrate handelsüblich erhältlich sind, lässt sich somit eine örtlich selektive, die beschichteten Flächen aussparende Dotierung mit Aluminium mit vergleichsweise minimalem zusätzlichen Aufwand in der Massenproduktion erreichen, vergleichen mit dem bisher erforderlichen nachträglichen Abtragen von mit Aluminium dotierten Flächen oder Flächenteilen der Si-Substrate. Die Herstellung von nur auf einer Hauptfläche mit Aluminium dotierten Si-Substraten ist insbesondere für die Massenfertigung von Leistungs-Halbleitern bedeutsam. Wie oben anhand von Fig. 2 erläutert, können aber auch Teilbereiche von Flächen abgedeckt bzw. maskiert werden, wobei sich mit geeigneten Masken noch Feinstrukturen in der Grössenordnung von etwa 1 mm realisieren lassen, was in der Praxis von der jeweils erzielbaren Oberflächenqualität (Planarität, Rauhigkeit) im Grenzflächenbereich beeinflusst wird.

## Patentansprüche

1. Verfahren zum örtlich selektiven Dotieren eines im wesentlichen aus Silicium bestehenden flächigen Trägers für die Halbleiterfertigung in einem Diffusionsverfahren, bei welchem Aluminium als Dotiermittel im Vakuum bei Temperaturen über 500 °C auf die Oberfläche der zu dotierenden Bereich des Trägers aufgedampft und in den Träger eindiffundieren gelassen wird, wobei ein Teil der Oberfläche des Trägers mit einer auf dem Träger haftenden Siliciumdioxidschicht und einer Abdeckung oder Maske versehen ist, um die Dotierung des Trägers unter der Abdeckung oder Maske zu verhindern, dadurch gekennzeichnet, dass die Abdeckung oder Maske von der auf dem Träger haftenden Siliciumdioxidschicht zusammen mit einer durch randseitige Halterung an der Siliciumdioxidschicht unter mechanischem Druck anliegenden Abdeck- oder Maskenplatte gebildet wird.

2. Verfahren nach Patentanspruch 1, dadurch gekennzeichnet, dass die Abdeck- oder Maskenplatte mit einem Druck von mindestens 1 Pa an der Siliciumdioxidschicht anliegt.

3. Verfahren nach Patentanspruch 1 oder 2, dadurch gekennzeichnet, dass sowohl die Siliciumdioxidschicht als auch die daran anliegende Oberfläche der Abdeck- oder Maskenplatte jeweils eine ebenheit besser als □ 5 µm und eine Rauhigkeit besser als Ra = 0,4 µm besitzt, beide Werte bestimmt nach ISO-Norm 1302.

4. Verfahren nach einem der Patentansprüche 1-3, dadurch gekennzeichnet, dass der flächige Träger eine polygonale oder runde Platte mit zwei praktisch parallelen Hauptflächen ist, von denen die eine mindestens zum Teil mit einer aufgewachsenen Siliciumdioxidschicht versehen ist, und dass die an der Siliciumdioxidschicht anliegende Abdeck- oder Maskenplatte aus einem unter den Bedingungen des Diffusionsverfahrens praktisch inerten Material besteht und die Diffusion von Aluminium höchstens im gleichen Masse gestattet, wie der flächige Träger.

5. Verfahren nach Patentanspruch 4, dadurch gekennzeichnet, dass mehrere flächige Träger jeweils mit der mit Siliciumdioxidschicht versehenen Hauptfläche an einer gemeinsamen Abdeckplatte anliegen, z. B. auf der gemeinsamen Abdeckplatte aufliegen.

6. Verfahren nach Patentanspruch 4, dadurch gekennzeichnet, dass mehrere flächige Träger von praktisch gleicher Grösse zu Trägerpaaren verbunden werden, bei welchen die beiden Träger jedes Paares jeweils mit den mit Siliciumdioxidschicht versehenen Hauptflächen aneinanderliegen und der eine Träger eines Paares als Abdeckplatte für den anderen Träger dieses Paares wirkt.

7. Verfahren nach Patentanspruch 6, dadurch gekennzeichnet, dass jedes Trägerpaar während des Diffusionsverfahrens nur in seinem Randbereich gehalten wird.

8. Vorrichtung zur Durchführung des Verfahrens gemäss Patentanspruch 7, gekennzeichnet durch mindestens ein Rahmenelement zur randseitigen Halterung von mehreren Trägerpaaren in einer Mehrzahl von Ausnehmungen des Rahmenelements, wobei die Breiten der Ausnehmungen jeweils den Dicken eines Trägerpaares entsprechen.

9. Vorrichtung nach Patentanspruch 8, dadurch gekennzeichnet, dass die Ausnehmungen des rahmenelementes oder der Rahmenelemente zur Erzeugung eines Druckes von mindestens 1 Pa auf die in die Ausnehmungen eingesetzten Platten eines Plattenpaares ausgebildet sind.

10. Vorrichtung nach einem der Patentansprüche 8 oder 9, dadurch gekennzeichnet, dass das Rahmenelement im wesentlichen aus Silicium besteht.

## Claims

1. Process for the locally selective doping of a two-dimensional carrier, essentially consisting of silicon, for semiconductor manufacture, by a diffusion process in which aluminium as a doping agent is vapour-deposited in vacuo at temperatures above 500 °C on the surface of the carrier region which is to be doped and is allowed to diffuse into the carrier, a part of the surface of the carrier being provided with a silicon dioxide layer adhering to the carrier and with a cover or mask in order to prevent doping of the carrier underneath the cover or mask, characterised in that the cover or mask is formed by the silicon dioxide layer, adhering to the carrier, together with a covering or masking plate bearing under mechanical pressure against the silicon dioxide layer as a result of fixing at the edge.

2. Process according to Patent Claim 1, characterised in that the covering or masking plate bears against the silicon dioxide layer with a pressure of at least 1 Pa.

3. Process according to Patent Claim 1 or 2, characterised in that both the silicon dioxide layer and the surface, bearing against it, of the covering or masking plate each have a levelness of better than □ 5 µm and a roughness better than Ra = 0.4 µm, both values being determined in accordance with ISO Standard 1302.

4. A process according to one of Patent Claims 1-3, characterised in that the two-dimensional carrier is a polygonal or round plate having two virtually parallel main surfaces, one of which is at least partially provided with an epitaxial silicon dioxide layer, and that the covering or masking plate, bearing against the silicon dioxide layer, consists of a material which is virtually inert under the conditions of the diffusion process and allows diffusion of aluminium at most to the same extent as the two-dimensional carrier.

5. Process according to Patent Claim 4, characterised in that several two-dimensional carriers each bear with the main surface, provided with the silicon dioxide layer, against a common covering plate, for example rest on the common covering plate.

6. Process according to Patent Claim 4, characterised in that several two-dimensional carriers of virtually the same size are joined into carrier pairs, in which the two carriers of each pair bear against each other with the main surfaces provided with the silicon dioxide layer and one carrier of a pair acts as the covering plate for the other carrier of this pair.

7. Process according to Patent Claim 6, characterised in that each carrier pair is fixed only in its edge region during the diffusion process.

8. Apparatus for carrying out the process according to Patent Claim 7, characterised by at least one frame element for fixing the edges of several carrier pairs in a plurality of recesses in the frame element, the widths of the recesses each corresponding to the thicknesses of a carrier pair.

9. Apparatus according to Patent Claim 8, characterised in that the recesses in the frame element or elements are designed to exert a pressure of at least 1 Pa on the plates of a pair of plates inserted into the recesses.

10. Apparatus according to one of Patent Claims 8 or 9, characterised in that the frame element consists essentially of silicon.

## Revendications

1. Procédé pour le dopage localement sélectif d'un support plan consistant essentiellement en silicium pour la fabrication de semi-conducteurs par un procédé de diffusion, suivant lequel on évapore de l'aluminium comme agent de dopage sous vide à des températures de plus de 500 °C sur la surface de la région à doper du support et on le laisse pénétrer par diffusion dans le support, une partie de la surface du support étant munie d'une couche de dioxyde de silicium adhérant au support, ainsi que d'une couverture ou d'un masque, afin d'empêcher le dopage du support sous la couverture ou le masque, caractérisé en ce que la couverture ou le masque, caractérisé en ce que la couverture ou le masque est formé par la couche de dioxyde de silicium adhérant au support conjointement avec une plaque de couverture ou de masquage applique sous pression mécanique sur la couche de dioxyde de silicium par maintien latéral.

2. Procédé suivant la revendication 1, caractérisé en ce que la plaque de couverture ou de masquage est appliquée avec une pression d'au moins 1 Pa sur la couche de dioxyde de silicium.

3. Procédé suivant la revendication 1 ou 2, caractérisé en ce que tant la couche de dioxyde de silicium que la surface contiguë de la plaque de couverture ou de masquage ont une planéité meilleure que □ 5 μm et une rugosité meilleure que Ra = 0,4 m, les deux grandeurs étant déterminées suivant la norme ISO 1302.

4. Procédé suivant l'une des revendications 1-3, caractérisé en ce que le support plan est une plaque polygonale ou ronde présentant deux faces principales pratiquement parallèles, dont l'une est munie au moins pour partie d'une couche de dioxyde de silicium formée par croissance et en ce que la plaque de couverture ou de masquage contiguë à la couche de dioxyde de silicium consiste en une matière pratiquement inerte dans les conditions du procédé de diffusion et ne permet la diffusion de l'aluminium qu'au maximum dans la même mesure que le support plan.

5. Procédé suivant la revendication 4, caractérisé en ce que plusieurs supports plans sont appliqués chaque fois par la face principale munie d'une couche de dioxyde de silicium contre une plaque de couverture commune, par exemple reposent sur la plaque de couverture commune.

6. Procédé suivant la revendication 4, caractérisé en ce que plusieurs supports plans de grandeur pratiquement égale sont assemblés en paires de supports, dans lesquelles les deux supports de chaque paire sont contigus par leur face principale munie de la couche de dioxyde de silicium et l'un des supports d'une paire sert de plaque de couverture pour l'autre, support de la paire.

7. Procédé suivant la revendication 6, caractérisé en ce que chaque paire de supports est maintenue uniquement dans sa région marginale pendant le procédé de diffusion.

8. Appareil pour l'exécution du procédé suivant la revendication 7, caractérisé en ce qu'il comprend au moins un élément de châssis pour le maintien marginal de plusieurs paires de supports dans plusieurs évidements de l'élément de châssis, les largeurs des évidements correspondant chaque fois à l'épaisseur d'une paire de supports.

9. Appareil suivant la revendication 8, caractérisé en ce que les évidements de l'élément de châssis ou des éléments de châssis sont conformes pour exercer une pression d'au moins 1 Pa sur les plaques d'une paire de plaques insérée dans les évidements.

10. Appareil suivant la revendication 8 ou 9, caractérisé en ce que l'élément de châssis consiste essentiellement en silicium.

Fig.1

Fig. 2

Fig.3

Fig.4

Fig. 5